# EUROPÄISCHE PATENTSCHRIFT

(11) **EP 1 198 881 B1**
(45) Veröffentlichungstag und Bekanntmachung des Hinweises auf die Patenterteilung: **28.07.2004**
(21) Anmeldenummer: 00951200.5
(22) Anmeldetag: 31.05.2000
(51) Int. Cl.: H03H 9/145

(54) **AKUSTISCHES OBERFLÄCHENWELLENFILTER**
SURFACE ACOUSTIC WAVE FILTER
FILTRE A ONDES ACOUSTIQUES DE SURFACE

(30) Priorität: 03.06.1999 DE 19925798; 06.09.1999 DE 19943072
(43) Veröffentlichungstag der Anmeldung: 24.04.2002
(73) Patentinhaber: Tele Filter Zweigniederlassung der Dover Germany GmbH, 14513 Teltow (DE)
(72) Erfinder: MARTIN, Günter, D-01307 Dresden (DE)
(74) Vertreter: Rauschenbach, Dieter, Dipl.-Ing. (FH)
(86) Internationale Anmeldenummer: PCT/DE2000/001808
(87) Internationale Veröffentlichungsnummer: WO 2000/076065

(56) Entgegenhaltungen:
- WO-A-97/10646
- DE-A- 2 656 154
- US-A- 5 818 310

## Beschreibung

### Technisches Gebiet

Die Erfindung bezieht sich auf das Gebiet Elektrotechnik/Elektronik. Objekte, bei denen die Anwendung möglich und zweckmäßig ist, sind Bauelemente auf der Basis akustischer Oberflächenwellen wie breitbandige Bandpassfilter und Verzogerungsleitungen.

### Stand der Technik

Es sind Wandler für akustische Oberflächenwellen bekannt, bei denen auf einem piezoelektrischen Substrat zwei interdigitale Wandler mit verteilter akustischer Reflexion, die aus Zinkengruppen zusammengesetzt sind, angeordnet sind.

Bei einer speziellen Ausführung (WO 97/10646) [1] sind interdigitale Wandler mit sich verjüngender Struktur aus Zinkengruppen zusammengesetzt, die aus zwei oder drei Zinken bestehen. Im Fall der Existenz von drei Zinken pro Zinkengruppe bilden zwei dieser Zinken ein reflexionsloses Zinkenpaar, während die jeweils dritte Zinke eine Reflektorzinke ist. Typischerweise beträgt der Abstand zwischen den Mittellinien der Reflektorzinke und der dieser Reflektorzinke benachbarten Zinke des Zinkenpaares 3λ/8 (λ ist die der Mittenfrequenz zugeordnete Wellenlänge längs einer Geraden, die parallel zu den Sammelelektroden in vorgegebenem Abstand von einer dieser Sammelelektroden verläuft.) Infolgedessen hat jede Zinkengruppe eine hinsichtlich der erzeugten Wellenamplitude bevorzugte Richtung. Deshalb ist eine Wandlerstruktur dieser Art ein Einphasen-Unidirektionalwandler (Single Phase Unidirectional Transducer, abgekürzt: SPUDT). Wenn die Breite der Reflektorzinke λ/4 bzw. 3λ/8 beträgt, so werden die Zinkengruppen als EWC- bzw. DART-Zellen bezeichnet. Bei dieser Lösung sind die Zinkenbreiten als Funktion der Quellund/oder Lastimpedanz so gewählt, dass sich die an den Zinken reflektierten und an der Quell-/Lastimpedanz regenerierten Wellen gegenseitig kompensieren, so dass ein solcher Wandler insgesamt reflexionsfrei ist. Infolgedessen treten trotz Anpassung keine störenden Echos auf.

Bei einer zweiten speziellen Ausführung (US 5 818 310) [2] werden die Übertragungseigenschaften von akustischen Oberflächenwellenfiltern verbessert, indem eine Kombination von Serienblock- und Zinkenbreitenwichtung auf wenigstens einen der Wandler angewandt wird. Beide Wichtungsverfahren liefern eine gleichmäßige Wichtung über das gesamte Wellenfeld. Ein solcher Wandler kann in einem Filter mit einem Wandler kombiniert werden, der ein homogenes Strahlprofil erfordert, z. B. mit einem überlappungsgewichteten Wandler. Die Zinkenbreitenwichtung sorgt für eine feinere Abstufung der Wichtungsfaktoren als das mit der Serienblockwichtung möglich ist. Ausgewählte Wandler Geometrien werden in Breitbandfiltern mit verjüngten Elektrodenzinken realisiert. Hinsichtlich verjüngter Wandlerstrukturen werden im Vergleich zu [1] keine neuen Merkmale beschrieben.

In einer dritten speziellen Ausführung (DE 26 56 154) [3] werden ebenfalls Wandler mit sich verjüngender Struktur vorgestellt. Sie dienen zum Auslesen von Informationen mit Hilfe von akustischen Oberflächenwellen aus einer eindimensionalen Matrix, die sich an der Oberfläche eines Festkörpers befindet. In einer Ausführungsform ist die Verjüngung der Wandlerstruktur stufenförmig ausgeführt. Dadurch entstehen Partialwandler, die sich in ihrer Mittenfrequenz voneinander unterscheiden. Das ist für die vorgesehene Anwendung insofern zweckmäßig, weil, während der betrachtete Partialwandler maximale Wellenanregung aufweist, die Wellenanregung durch benachbarte Partialwandler zu Null gemacht werden kann.

Bei einer vierten speziellen Ausführung (P. Ventura, M. Solal, P. Dufilié, J.M. Hodé und F. Roux, 1994- IEEE Ultrasonics Symposium Proceedings S. 1-6) [4] werden die infolge der Reflexionen an den Wandlern entstehenden Echos nicht nur nicht unterdrückt, sondern zu einer Verlängerung der Impulsantwort, die einen kleineren Formfaktor (entsprechend einer größeren Flankensteilheit) und/oder eine größere Bandbreite zur Folge hat, benutzt. Die Layouts, akustischer Oberflächenwellenfilter mit den gleichen Parametern ohne diese Eigenschaften müssen wesentlich länger sein. Wie die akustischen Reflexionen über die Wandler verteilt sein müssen, um die geforderten Filterparameter zu erhalten, wird gewöhnlich durch ein Optimierungsverfahren bestimmt. Da die Lösung [4] aufgrund der nutzbringenden Einbeziehung der Echos in den Filterentwurf eigentlich ein Resonator mit ineinander verschachtelten Anregungs- und Reflexionszentren ist, wird ein Bauelement dieser Art Resonantes SPUDT- (RSPUDT-) Filter genannt.

Die Ausführung [4] hat den Nachteil, dass die Bandbreite von dieser Art von Filtern sinnvollerweise maximal in der Nähe von 1% liegt. Breitbandfilter mit niedriger Einfügedämpfung können demzufolge nicht realisiert werden.

### Darstellung der Erfindung

Der Erfindung liegt die Aufgabe zugrunde, akustische Oberflächenwellenfilter der SPUDT-Art so zu verändern, dass Breitbandfilter mit niedriger Einfügedämpfung und kleinem Formfaktor ohne wesentliche Vergrößerung des Layouts hergestellt werden können.

Diese Aufgabe wird nach der Erfindung mit dem in den Patentansprüchen beschriebenen akustischen Oberflächenwellenfilter gelöst.

Die Erfindung geht dabei von einem Oberflächenwellenfilter der SPUDT-Art aus, bei dem auf einem piezoelektrischen Substrat zwei Wandler mit verteilter akustischer Reflexion angeordnet sind, die aus Zinkengruppen und Sammelelektroden bestehen, wobei die Zinken der Wandler eine in Richtung einer der beiden Sammelelektroden sich verjüngende Struktur bilden, bei der längs zweier paralleler gerader Linien, die alle Zinken der Wandler so schneiden, dass in jedem Wandler entlang der Linien alle Zinkengruppen gleich breit sind, sich zwischen den beiden Linien die Breite der Zinken und Lücken um einen Faktor unterscheidet.

Nach der Erfindung unterscheidet sich zwischen den beiden Linien auch der Zwischenraum zwischen den beiden Wandlern um den Faktor, derart, dass sich die geradlinigen Verlängerungen der Zinken beider Wandler über das Zinkengebiet hinaus in ein und demselben Punkt schneiden.

Die sich erfindungsgemäß verjüngende Struktur kann als Parallelschaltung von sehr vielen schmalen Filterkanälen angesehen werden, deren Wandler sich lediglich durch ihre Periodenlänge und damit durch ihre Mittenfrequenz unterscheiden. Infolge dieser Verjüngung der Struktur wird deshalb ein Bereich von Mittenfrequenzen festgelegt, der, gleichzeitig die Bandbreite bestimmt. Je größer der Grad der Verjüngung, desto größer ist die Bandbreite. Die Flankensteilheit, die den Formfaktor bestimmt, kann jedoch kaum durch den Verjüngungsgrad beeinflusst werden, sondern wird hauptsächlich von der Konstruktion der Filterkanäle bestimmt. Die erfindungsgemäße Lösung bietet den Vorteil, auch bei Filtern mit sich verjüngender Struktur die Echos so zur Verlängerung der Impulsantwort zu verwenden, als ob jeder Filterkanal und infolgedessen auch das gesamte Filter wesentlich mehr Wellenquellen hätte oder, mit anderen Worten, wesentlich länger wäre als das vorliegende Layout. Diesen Vorteil bietet die Lösung [1] nicht, weil die Echos in jedem Filterkanal dadurch unterdrückt sind, dass jeder Wandlerkanal in jedem Filterkanal für sich und demzufolge jeder Wandler als ganzes durch gegenseitige Kompensation von Reflexion und Regeneration reflexionslos ist.

Die Erfindung kann wie folgt zweckmäßig ausgestaltet sein.

Die Verjüngung kann darin bestehen, dass sich die Breite der Zinken und der Lücken zwischen ihnen stufenartig verringert.

Dabei ist es zweckmäßig, wenn alle äquivalenten Eckpunkte ein und derselben Zinkenkante auf einer Kurve liegen, wobei sich die geradlinigen Verlängerungen aller dieser Kurven der beiden Wandler über das jeweilige Zinkengebiet hinaus in ein und demselben Punkt schneiden.

Dabei ist es besonders zweckmäßig, wenn jede Zinkenstufe einen rechteckförmigen Zinkenabschnitt mit jeweils zwei zur Ausbreitungsrichtung senkrechten bzw. parallelen Begrenzungen enthält, wobei die zwei zur Ausbreitungsrichtung parallelen Begrenzungen aller Zinkenabschnitte der gleichen Stufe jeweils eine gerade Begrenzungslinie bilden, so dass die jeweils zwischen diesen beiden geraden Begrenzungslinien liegenden Zinkengebiete Filterkanäle darstellen, die durch Zwischengebiete voneinander getrennt sind.

Alle Kurven, auf der jeweils alle äquivalenten Eckpunkte ein und derselben Zinkenkante liegen, können gerade Linien sein.

Eine Zinkengruppe kann zwei oder drei Zinken enthalten. Im letzteren Fall können jeweils zwei Zinken einer Zinkengruppe ein Zinkenpaar bilden, wobei die Zinken eines Zinkenpaares gleich breit und an verschiedene Sammelelektroden angeschlossen sind sowie so zueinander angeordnet sind, dass das Zinkenpaar insgesamt reflexionslos ist und die jeweils dritte Zinke eine Reflektorzinke ist. Besonders zweckmäßige Ausgestaltungen sind, wenn jede Zinkengruppe eine DART- oder EWC-Zelle ist.

Jeder Zinkengruppe kann die Quellstärke der Amplitudenanregung durch eine Quellstärkenfunktion und ein Reflexionsfaktor durch eine Reflexionsfunktion zugeordnet sein, wobei die Quellstärkenfunktion und die Reflexionsfunktion durch ein Optimierungsverfahren bestimmt sein können.

Die Reflexionsfunktion kann so beschaffen sein, dass der Reflexionsfaktor in wenigstens einer Zinkengruppe gegenüber den anderen Zinkengruppen das entgegengesetzte Vorzeichen hat. Es ist zweckmäßig, diesen Vorzeichenwechsel dadurch zu realisieren, dass der Abstand der Reflektorzinke der besagten Zinkengruppe von den anderen Reflektorzinken nλ/2 +λ/4 beträgt, wobei λ die der Mittenfrequenz zugeordnete Wellenlänge längs einer geraden Linie ist, die alle Zinken so schneidet, dass in jedem Wandler entlang dieser Linie alle Zinkengruppen gleich breit sind und n eine ganze Zahl ist.

Für die Einstellung einer bestimmten Quellstärkenfunktion ist es zweckmäßig, wenn wenigstens einige Zinkengruppen, bezeichnet als strukturierte Zinkengruppen, in wenigstens einem Wandler parallel zu den Sammelelektroden in eine Anzahl von Subwandlern unterteilt sind, die elektrisch in Reihe geschaltet sind. Dabei ist es besonders zweckmäßig, wenn alle Subwandler ein und derselben strukturierten Zinkengruppe die gleiche Apertur haben.

Die Anzahl der Subwandler in wenigstens einer strukturierten Zinkengruppe kann sich von derjenigen in den anderen strukturierten Zinkengruppen unterscheiden.

Für die Einstellung einer bestimmten Quellstärke bzw. eines bestimmten Reflexionsfaktors in bestimmten Zinkengruppen ist es zweckmäßig, wenn sich die Breiten der zum jeweiligen Zinkenpaar gehörenden Zinken bzw. die Breite der Reflektorzinke in wenigstens einer Zinkengruppe in wenigstens einem Wandler von denen in den übrigen Zinkengruppen unterscheiden bzw. unterscheidet.

Die Erfindung ist nachstehend anhand eines Ausführungsbeispiels und einer zugehörigen Zeichnung näher erläutert.

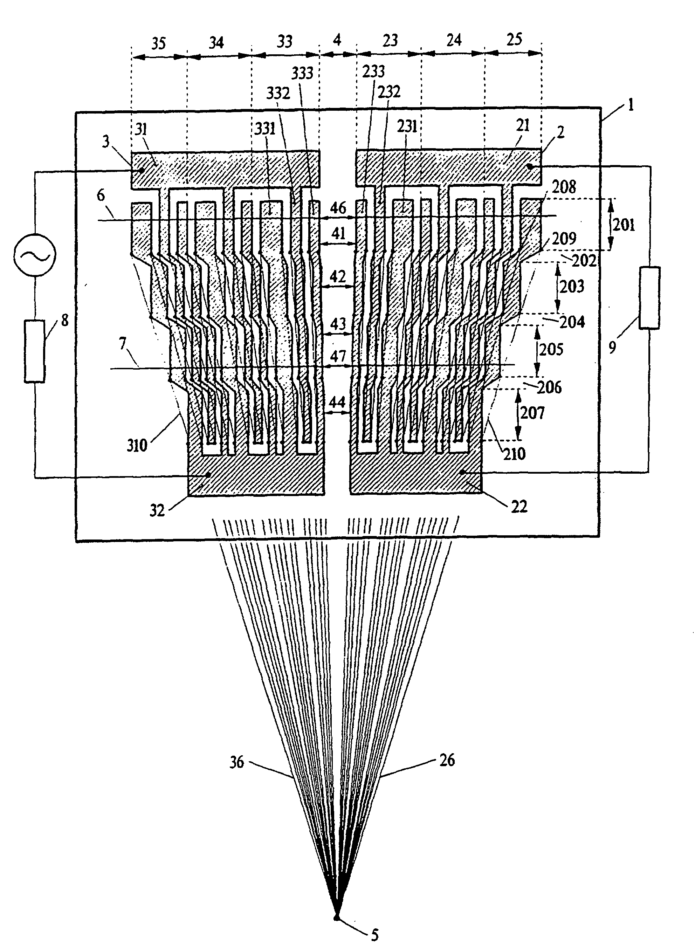

### Kurze Beschreibung der Zeichnung

Die Zeichnung zeigt ein akustisches Oberflächenwellenfilter, das aus zwei interdigitalen Wandlern besteht, die auf einem piezoelektrischen Substrat angeordnet sind.

### Bester Weg zur Ausführung der Erfindung

Bei dem in der Zeichnung dargestellten akustischen Oberflächenwellenfilter sind auf einem piezoelektrischen Substrat 1 zwei interdigitalen Wandler 2 und 3 angeordnet. Zwischen den Wandlern 2 und 3 ist ein Zwischenraum 4 vorhanden. Der Wandler 2 ist aus den Sammelelektroden 21 und 22 sowie aus den Zinkengruppen 23, 24 und 25 zusammengesetzt.

Diese sind stellvertretend für wesentlich mehr Zinkengruppen, aus denen der Wandler 2 besteht, dargestellt. Die Zinken des Wandlers 2 bilden in Richtung der Sammelelektrode 22 eine sich verjüngende Struktur in dem Sinn, dass sich die Breite der Zinken und der Lücken zwischen ihnen stufenartig verringert. Die Zinkengruppen 23, 24 und 25 sind EWC-Zellen. Alle Zinkengruppen 23, 24 und 25 sind, von der unterschiedlichen mittleren Neigung ihrer Zinken abgesehen, identisch aufgebaut. Deshalb wird lediglich die Zinkengruppe 23 näher beschrieben. Sie ist aus der Reflektorzinke 231 und den Zinken 232 und 233, die zusammen ein Zinkenpaar bilden, zusammengesetzt.

Der Wandler 3 ist aus den Sammelelektroden 31 und 32 sowie aus den Zinkengruppen 33, 34 und 35 zusammengesetzt. Diese sind stellvertretend für wesentlich mehr Zinkengruppen, aus denen der Wandler 3 besteht, dargestellt. Die Zinken des Wandlers 3 bilden in Richtung der Sammelelektrode 32 eine sich verjüngende Struktur in dem Sinn, dass sich die Breite der Zinken und der Lücken zwischen ihnen stufenartig verringert. Die Zinkengruppen 33, 34 und 35 sind EWC-Zellen. Alle Zinkengruppen 33, 34 und 35 sind, von der unterschiedlichen mittleren Neigung ihrer Zinken abgesehen, identisch aufgebaut. Deshalb wird lediglich die Zinkengruppe 33 näher beschrieben. Sie ist aus der Reflektorzinke 331 und den Zinken 332 und 333, die zusammen ein Zinkenpaar bilden, zusammengesetzt.

Das Filter ist aus den Filterkanälen 201, 203, 205 und 207 zusammengesetzt. Zwischen den benachbarten Filterkanälen 201 und 203, 203 und 205 sowie 205 und 207 befinden sich die Zwischengebiete 202, 204 und 206, in denen die Zinkenabschnitte benachbarter Filterkanäle, die zu ein und derselben Zinke gehören, miteinander verbunden sind. Der Zwischenraum 4 zwischen den Wandlern 2 und 3 wird in diesen Filterkanälen repräsentiert durch die Zwischenräume 41, 42, 43 und 44. Alle Zinkenkanten sind zueinander parallel. Jedoch sind äquivalente Zinkenkanten in verschiedenen Filterkanälen so gegeneinander verschoben, dass die Schnittpunkte 208 der linken Kanten äquivalenter Abschnitte ein und derselben Zinke mit der unteren Begrenzungslinie des jeweiligen Filterkanals in verschiedenen Filterkanälen auf ein und derselben geraden Linie liegen. In analoger Weise trifft das auch für die jeweils rechten Zinkenkanten zu, bei denen die Punkte 209 die gleiche Bedeutung haben wie die Punkte 208. Beispiele für solche gerade Linien sind mit 210 und 310 im Bereich der Wandler 2 bzw. 3 bezeichnet. Unter der mittleren Neigung einer Zinkenkante wird die Neigung der jeweiligen geraden Linie verstanden.

Die geraden Linien 210 und 310 sind so geneigt, dass sich deren geradlinige Verlängerungen 26 bzw. 36 über das jeweilige Zinkengebiet hinaus in ein und demselben Punkt 5 schneiden. Längs zweier paralleler gerader Linien 6 und 7, die alle Zinken der Wandler 2 und 3 so schneiden, dass in jedem Wandler entlang dieser Linien alle Zinkengruppen gleich breit sind, unterscheiden sich nicht nur äquivalente Zinkenund Luckenbreiten sondern auch die Zwischenräume 46 und 47 zwischen beiden Wandlern nur um ein und denselben Faktor. Demzufolge unterscheiden sich in beliebig ausgewählten Filterkanälen nicht nur äquivalente Zinken- und Lückenbreiten sondern auch zwei der Zwischenräume 41, 42, 43 und 44 zwischen beiden Wandlern, die zu den jeweils ausgewählten Filterkanälen gehören, nur um ein und denselben Faktor. Diese Eigenschaft garantiert, dass die Übertragungseigenschaften (z.B. die Admittanzmatrix) aller Filterkanäle auf die Übertragungseigenschaften eines einzigen Filterkanals zurückgeführt werden können. Dadurch wird die Rechenzeit, die zur Analyse eines Filters nach dem Ausführungsbeispiel erforderlich ist, stark reduziert. Da ein Optimierungsverfahren eine Filteranalyse viele Male durchführen muss, erfordert die Bestimmung der Quellstärkenund Reflexionskoeffizienten durch ein solches Verfahren nicht wesentlich mehr Zeit als die vergleichbare Prozedur bei RSPUDT-Filtern.

Alle Zinken 232 und 233, 332 und 333, die Zinkenpaare bilden, sowie die nicht gezeigten, dazu äquivalenten Zinken sind innerhalb eines Filterkanals gleich breit. Alle ein Zinkenpaar bildenden Zinken haben einen Abstand von λ/4 und sind deshalb reflexionslos, wobei λ die Breite einer Zinkengruppe im jeweiligen Filterkanal ist. Die Reflektorzinken 231, 331 und nicht gezeigte, dazu äquivalente Zinken jedoch sind unterschiedlich breit, um eine bestimmte Reflexionsfunktion zu realisieren. Diese Reflexionsfunktion ist so gewählt, dass die an den Reflektorzinken reflektierten Wellen zusammen mit den durch den jeweiligen Quellwiderstand '8 und Lastwiderstand 9 regenerierten Wellen eine Verlängerung der Impulsantwort des Filters bewirken, die dessen Formfaktor und/oder Bandbreite verringert. Der Reflexionsfaktor einiger nicht gezeigter Zinkengruppen hat ein, verglichen mit den anderen Zinkengruppen, entgegengesetztes Vorzeichen. Das ist dadurch realisiert, dass der Abstand der Reflektorzinken in den betroffenen Zinkengruppen von den anderen Reflektorzinken nλ/2 +λ/4 beträgt, wobei n eine ganze Zahl ist. Die Reflektorzinken der gezeigten Zinkengruppen 23, 24 und 25 sowie 33, 34 und 35 haben Abstände gleich nλ voneinander. Wenn jedoch der Reflexionsfaktor einer dieser Zinkengruppen negativ wäre, so müsste die Reflexionszinke dieser Zinkengruppe gegenüber ihrer Position in der Zeichnung um 3/4λ, 5/4λ oder 7/4λ verschoben sein.

## Patentansprüche

1. Akustisches Oberflächenwellenfilter, basierend auf interdigitalen Einphasen-Unidirektionalwandlern (Single Phase Unidirectional Transducer / SPUDT /), bei dem auf einem piezoelektrischen Substrat (1) zwei derartige Wandler (2;3) mit verteilter akustischer Reflexion angeordnet sind, die aus Zinkengruppen (23-25;33-35) und Sammelelektroden (21;22;31;32) bestehen, wobei die Zinken der Wandler eine in Richtung einer der beiden Sammelelektroden sich verjüngende Struktur bilden, bei der längs zweier paralleler gerader Linien (6; 7), die alle Zinken der Wandler (2;3) so schneiden, dass in jedem Wandler (2;3) entlang der Linien (6;7) alle Zinkengruppen (23-25;33-35) gleich breit sind, sich zwischen den beiden Linien (6;7) die Breite der Zinken (231-233;331-333) und Lücken zwischen diesen um einen Faktor unterscheidet, **dadurch gekennzeichnet, dass** sich zwischen den beiden Linien (6;7) auch der Zwischenraum (46;47) zwischen den beiden Wandlern (2;3) um den Faktor unterscheidet, derart, dass sich die geradlinigen Verlängerungen (26;36) der Zinken (231-233;331-333) beider Wandler (2;3) über das Zinkengebiet hinaus in ein und demselben Punkt (5) schneiden.

2. Akustisches Oberflächenwellenfilter nach Anspruch 1, **dadurch gekennzeichnet, dass** bei der sich verjüngenden Struktur die Breite der Zinken (231-233;331-333) und der Lücken zwischen ihnen stufenartig verringert ist.

3. Akustisches Oberflächenwellenfilter nach Anspruch 2, **dadurch gekennzeichnet, dass** alle Eckpunkte (208;209) ein und derselben Zinkenkante auf einer Kurve liegen, wobei sich die geradlinigen Verlängerungen (26;36) aller dieser Kurven der beiden Wandler (2;3) über das jeweilige Zinkengebiet hinaus in ein und demselben Punkt (5) schneiden.

4. Akustisches Oberflächenwellenfilter nach Anspruch 3, **dadurch gekennzeichnet, dass** jede Zinkenstufe einen rechteckförmigen Zinkenabschnitt mit jeweils zwei zur Ausbreitungsrichtung senkrechten bzw. parallelen Begrenzungen enthält, wobei die zwei zur Ausbreitungsrichtung parallelen Begrenzungen aller Zinkenabschnitte der gleichen Stufe jeweils eine gerade Begrenzungslinie bilden, so dass die jeweils zwischen diesen beiden geraden Begrenzungslinien liegenden Zinkengebiete Filterkanäle (201;203;205;207) darstellen, die durch Zwischengebiete (202;204;206) voneinander getrennt sind.

5. Akustisches Oberflächenwellenfilter nach Anspruch 3, **dadurch gekennzeichnet, dass** alle Kurven gerade Linien (210;310) sind.

6. Akustisches Oberflächenwellenfilter nach Anspruch 1, **dadurch gekennzeichnet, dass** jede Zinkengruppe (23-25;33-35) beider Wandler (2;3) zwei Zinken enthält.

7. Akustisches Oberflächenwellenfilter nach Anspruch 1, **dadurch gekennzeichnet, dass** jede Zinkengruppe (23-25;33-35) beider Wandler (2;3) drei Zinken enthält.

8. Akustisches Oberflächenwellenfilter nach Anspruch 7, **dadurch gekennzeichnet, dass** jeweils zwei Zinken (232;233 bzw. 332;333) einer Zinkengruppe (23-25;33-35) ein Zinkenpaar bilden, wobei die Zinken eines Zinkenpaares gleich breit und an verschiedene Sammelelektroden (21;22 bzw. 31;32) angeschlossen sind sowie so zueinander angeordnet sind, dass das Zinkenpaar insgesamt reflexionslos ist und die jeweils dritte Zinke (231 bzw. 331) eine Reflektorzinke ist.

9. Akustisches Oberflächenwellenfilter nach Anspruch 8, **dadurch gekennzeichnet, dass** jede Zinkengruppe (23-25;33-35) eine DART-Zelle ist.

10. Akustisches Oberflächenwellenfilter nach Anspruch 8, **dadurch gekennzeichnet, dass** jede Zinkengruppe (23-25;33-35) eine EWC-Zelle ist.

11. Akustisches Oberflächenwellenfilter nach Anspruch 8, **dadurch gekennzeichnet, dass** jeder Zinkengruppe (23-25;33-35) die Quellstärke der Amplitudenanregung durch eine Quellstärkenfunktion zugeordnet ist.

12. Akustisches Oberflächenwellenfilter nach Anspruch 8, **dadurch gekennzeichnet, dass** jeder Zinkengruppe (23-25;33-35) ein Reflexionsfaktor durch eine Reflexionsfunktion zugeordnet ist.

13. Akustisches Oberflächenwellenfilter nach Anspruch 12, **dadurch gekennzeichnet, dass** der Reflexionsfaktor in wenigstens einer Zinkengruppe (23-25;33-35) gegenüber den anderen Zinkengruppen das entgegengesetzte Vorzeichen hat, das dadurch realisiert ist, dass der Abstand der Reflektorzinke (231;331) der besagten Zinkengruppe von den anderen Reflektorzinken nλ/2 +λ/4 beträgt, wobei λ die der Mittenfrequenz zugeordnete Wellenlänge längs einer geraden Linie (6;7) ist, die alle Zinken so schneidet, dass in jedem Wandler (2;3) entlang dieser Linie alle Zinkengruppen (23-25;33-35) gleich breit sind und n eine ganze Zahl ist.

14. Akustisches Oberflächenwellenfilter nach Anspruch 11 oder 12, **dadurch gekennzeichnet, dass** die Quellstärkenfunktion und die Reflexionsfunktion durch ein Optimierungsverfahren bestimmt sind.

15. Akustisches Oberflächenwellenfilter nach Anspruch 11, **dadurch gekennzeichnet, dass** wenigstens einige Zinkengruppen (23-25;33-35), bezeichnet als strukturierte Zinkengruppen, in wenigstens einem Wandler parallel zu den Sammelelektroden in eine Anzahl von Subwandlern unterteilt sind, die elektrisch in Reihe geschaltet sind.

16. Akustisches Oberflächenwellenfilter nach Anspruch 15, **dadurch gekennzeichnet, dass** alle Subwandler ein und derselben strukturierten Zinkengruppe die gleiche Apertur haben.

17. Akustisches Oberflächenwellenfilter nach Anspruch 15, **dadurch gekennzeichnet, dass** sich die Anzahl der Subwandler in wenigstens einer strukturierten Zinkengruppe von derjenigen in den anderen strukturierten Zinkengruppen unterscheidet.

18. Akustisches Oberflächenwellenfilter nach Anspruch 8, **dadurch gekennzeichnet, dass** sich die Breiten der zum jeweiligen Zinkenpaar gehörenden Zinken (232;233) in wenigstens einer Zinkengruppe (23-25;33-35) in wenigstens einem Wandler (2;3) von denen in den übrigen Zinkengruppen unterscheiden.

19. Akustisches Oberflächenwellenfilter nach Anspruch 8, **dadurch gekennzeichnet, dass** sich die Breite der Reflektorzinke (231;331) in wenigstens einer Zinkengruppe (23-25;33-35) in wenigstens einem Wandler (2;3) von denen in den übrigen Zinkengruppen unterscheidet.

## Claims

1. Surface acoustic wave filter, based on interdigital single-phase unidirectional transducers (SPUDT), in which two such transducers (2; 3) are arranged with distributed acoustic reflection on a piezoelectric substrate (1) and comprise tine-groups (23-25; 33-35) and collecting electrodes (21; 22; 31; 32), with the tines of the transducers forming a structure which tapers in the direction of one of the two collecting electrodes, in which, along two parallel straight lines (6; 7) which intersect all the tines of the transducers (2; 3) such that all of the tine groups (23-25; 33-35) have the same width along the lines (6; 7) in each transducer (2; 3), the width of the tines (231-233; 331-333) and gaps between them between the two lines (6; 7) differs by a factor, **characterized in that** the space (46; 47) between the two transducers (2; 3) between the two lines (6; 7) also differs by the factor, such that the linear extensions (26; 36) of the tines (231-233; 331-333) of both transducers (2; 3) intersect at one and the same point (5) beyond the tine region.

2. Surface acoustic wave filter according to Claim 1, **characterized in that**, in the tapering structure, the width of the tines (231-233; 331-333) and of the gaps between them is reduced like steps.

3. Surface acoustic wave filter according to Claim 2, **characterized in that** all of the corner points (208; 209) of one and the same tine edge lie on a curve, with the linear extensions (26; 36) of all of these curves of the two transducers (2; 3) intersecting at one and the same point (5) beyond the respective tine region.

4. Surface acoustic wave filter according to Claim 3, **characterized in that** each tine step contains a rectangular tine section with in each case two boundaries at right angles to and parallel to the propagation direction, with the two boundaries of all of the tine sections of the same step which are parallel to the propagation direction in each case forming a straight boundary line, so that the tine regions which are in each case located between these two straight boundary lines represent filter channels (201; 203; 205; 207) which are separated from one another by intermediate regions (202; 204; 206).

5. Surface acoustic wave filter according to Claim 3, **characterized in that** all the curves are straight lines (210; 310).

6. Surface acoustic wave filter according to Claim 1, **characterized in that** each tine group (23-25; 33-35) of the two transducers (2; 3) contains two tines.

7. Surface acoustic wave filter according to Claim 1, **characterized in that** each tine group (23-25; 33-35) of the two transducers (2; 3) contains three tines.

8. Surface acoustic wave filter according to Claim 7, **characterized in that** two tines (232; 233 and 332; 333) of one tine group (23-25; 33-35) in each case form a tine pair, with the tines of a tine pair having the same width and being connected to different collecting electrodes (21; 22 and 31; 32), and being arranged with respect to one another such that the tine pair is reflectionless overall, and the third tine (231 or 331) in each case is a reflector tine.

9. Surface acoustic wave filter according to Claim 8, **characterized in that** each tine group (23-25; 33-35) is a DART cell.

10. Surface acoustic wave filter according to Claim 8, **characterized in that** each tine group (23-25; 33-35) is an EWC cell.

11. Surface acoustic wave filter according to Claim 8, **characterized in that** the source strength of the amplitude excitation is associated with each tine group (23-25; 33-35) by means of a source strength function.

12. Surface acoustic wave filter according to Claim 8, **characterized in that** a reflection factor is associated with each tine group (23-25; 33-35) by means of a reflection function.

13. Surface acoustic wave filter according to Claim 12, **characterized in that** the reflection factor in at least one tine group (23-25; 33-35) has the opposite mathematical sign to the other tine groups, and this is achieved by the distance between the reflector tine (231; 331) in the said tine group and the other reflector tines being nλ/2 + λ/4, where λ is the wavelength associated with the mid-frequency along a straight line (6; 7) which intersects all the tines such that all the tine groups (23-25; 33-35) in each transducer (2; 3) have the same width along this line, and n is an integer.

14. Surface acoustic wave filter according to Claim 11 or 12, **characterized in that** the source strength function and the reflection function are determined by means of an optimization method.

15. Surface acoustic wave filter according to Claim 11, **characterized in that** at least some of the tine groups (23-25; 33-35), referred to as structured tine groups, in at least one transducer are subdivided into a number of sub-transducers (which are electrically connected in series) parallel to the collecting electrodes.

16. Surface acoustic wave filter according to Claim 15, **characterized in that** all of the sub-transducers in one and the same structured tine group have the same aperture.

17. Surface acoustic wave filter according to Claim 15, **characterized in that** the number of sub-transducers in at least one structured tine group differs from the number in the other structured tine groups.

18. Surface acoustic wave filter according to Claim 8, **characterized in that** the widths of the tines (232; 233) which are associated with the respective tine pair in at least one tine group (23-25; 33-35) in at least one transducer (2; 3) differ from the widths in the other tine groups.

19. Surface acoustic wave filter according to Claim 8, **characterized in that** the width of the reflector tine (231; 331) in at least one tine group (23-25; 33-35) in at least one transducer (2; 3) differs from the widths in the other tine groups.

## Revendications

1. Filtre à ondes de surface acoustiques, basé sur des convertisseurs unidirectionnels monophasés interdigitaux (Single Phase Unidirectional Transducer / SPUDT /), avec lequel deux convertisseurs (2 ; 3) de ce type à réflexion acoustique distribuée sont disposés sur un substrat piézoélectrique (1), lesquels se composent de groupes de dents (23-25 ; 33-35) et d'électrodes collectrices (21 ; 22 ; 31 ; 32), les dents des convertisseurs formant une structure qui se rétrécit en direction de l'une des deux électrodes collectrices, avec lequel le long de deux lignes droites parallèles (6 ; 7), qui croisent toutes les dents des convertisseurs (2 ; 3) de manière à ce que tous les groupes de dents (23-25 ; 33-35) sont de la même largeur le long des lignes (6 ; 7) dans chaque convertisseur (2 ; 3), la largeur des dents (231-233 ; 331-333) et les espaces entre celles-ci se différencient d'un facteur donné entre les deux lignes (6 ; 7), **caractérisé en ce que** l'espace intermédiaire (46 ; 47) entre les deux convertisseurs (2 ; 3) se différencie lui aussi du facteur donné entre les deux lignes (6 ; 7) de manière à ce que les prolongations rectilignes (26 ; 36) des dents (231-233 ; 331-333) des deux convertisseurs (2 ; 3) se croisent au-delà de la zone des dents en un seul et même point (5).

2. Filtre à ondes de surface acoustiques selon la revendication 1, **caractérisé en ce que** dans le cas de la structure qui se rétrécit, la largeur des dents (231-233 ; 331-333) et des espaces entre celles-ci se réduit graduellement.

3. Filtre à ondes de surface acoustiques selon la revendication 2, **caractérisé en ce que** tous les coins (208 ; 209) d'une seule et même arête de dent se trouvent sur une courbe, les prolongations rectilignes (26 ; 36) de toutes ces courbes des deux convertisseurs (2 ; 3) se croisant au-delà de la zone des dents en un seul et même point (5).

4. Filtre à ondes de surface acoustiques selon la revendication 3, **caractérisé en ce que** chaque étage de dent comprend une section de dent rectangulaire avec à chaque fois deux délimitations perpendiculaires ou parallèles par rapport au sens de l'élargissement, les deux délimitations parallèles au sens de l'élargissement de toutes les sections de dent du même étage formant à chaque fois une ligne de délimitation droite de manière à ce que les zones de dents qui se trouvent à chaque fois entre ces deux lignes de délimitation droites forment des canaux filtrants (201 ; 203 ; 205 ; 207) qui sont séparés les uns des autres par des zones intermédiaires (202 ; 204 ; 206).

5. Filtre à ondes de surface acoustiques selon la revendication 3, **caractérisé en ce que** toutes les courbes sont des lignes droites (210 ; 310).

6. Filtre à ondes de surface acoustiques selon la revendication 1, **caractérisé en ce que** chaque groupe de dents (23-25 ; 33-35) des deux convertisseurs (2 ; 3) comprend deux dents.

7. Filtre à ondes de surface acoustiques selon la revendication 1, **caractérisé en ce que** chaque groupe de dents (23-25 ; 33-35) des deux convertisseurs (2 ; 3) comprend trois dents.

8. Filtre à ondes de surface acoustiques selon la revendication 7, **caractérisé en ce que** deux dents (232 ; 233 ou 332 ; 333) d'un groupe de dents (23-25 ; 33-35) forment à chaque fois une paire de dents, les dents d'une paire de dents étant de la même largeur et étant raccordées à des électrodes collectrices (21 ; 22 ou 31 ; 32) différentes et étant disposées l'une par rapport à l'autre de telle manière que la paire de dent ne présente globalement aucune réflexion et la troisième dent (231 ou 331) est à chaque fois une dent de réflexion.

9. Filtre à ondes de surface acoustiques selon la revendication 8, **caractérisé en ce que** chaque groupe de dents (23-25 ; 33-35) est une cellule DART.

10. Filtre à ondes de surface acoustiques selon la revendication 8, **caractérisé en ce que** chaque groupe de dents (23-25 ; 33-35) est une cellule EWC.

11. Filtre à ondes de surface acoustiques selon la revendication 8, **caractérisé en ce que** l'intensité de source d'excitation d'amplitude est affectée à chaque groupe de dents (23-25 ; 33-35) par une fonction d'intensités de source.

12. Filtre à ondes de surface acoustiques selon la revendication 8, **caractérisé en ce qu'**un facteur de réflexion est affecté à chaque groupe de dents (23-25 ; 33-35) par une fonction de réflexion.

13. Filtre à ondes de surface acoustiques selon la revendication 12, **caractérisé en ce que** le facteur de réflexion présente le signe opposé dans au moins un groupe de dents (23-25 ; 33-35) par rapport à l'autre groupe de dents, ce qui est réalisé par le fait que l'écart entre les dents de réflexion (231 ; 331) dudit groupe de dents et les autres dents de réflexion est de nλ/2 + λ/4, λ, étant la longueur d'onde affectée à la fréquence centrale le long d'une ligne droite (6 ; 7) qui croise toutes les dents de manière à ce que dans chaque convertisseur (2 ; 3), tous les groupes de dents (23-25 ; 33-35) présentent la même largeur le long de cette ligne et n est un nombre entier.

14. Filtre à ondes de surface acoustiques selon la revendication 11 ou 12, **caractérisé en ce que** la fonction d'intensités de source et la fonction de réflexion sont déterminées par un procédé d'optimisation.

15. Filtre à ondes de surface acoustiques selon la revendication 11, **caractérisé en ce qu'**au moins quelques groupes de dents (23-25 ; 33-35), désignés sous le nom de groupes de dents structurés, sont divisés dans au moins un convertisseur parallèlement aux électrodes collectrices en un nombre donné de sous-convertisseurs qui sont branchés en série.

16. Filtre à ondes de surface acoustiques selon la revendication 15, **caractérisé en ce que** tous les sous-convertisseurs d'un seul et même groupe de dents structuré ont la même ouverture.

17. Filtre à ondes de surface acoustiques selon la revendication 15, **caractérisé en ce que** le nombre de sous-convertisseurs dans au moins un groupe de dents structuré est différent de celui dans les autres groupes de dents structurés.

18. Filtre à ondes de surface acoustiques selon la revendication 8, **caractérisé en ce que** les largeurs des dents (232 ; 233) faisant partie de la paire de dents correspondante dans au moins un groupe de dents (23-25 ; 33-35) dans au moins un convertisseur (2 ; 3) sont différentes de celles dans les autres groupes de dents.

19. Filtre à ondes de surface acoustiques selon la revendication 8, **caractérisé en ce que** la largeur de la dent de réflexion (231 ; 331) dans au moins un groupe de dents (23-25 ; 33-35) dans au moins un convertisseur (2 ; 3) est différente de celle dans les autres groupes de dents.
